Europäisches Patentamt

European Patent Office

Office européen des brevets

(11) Publication number: **0 051 304**
**B1**

# EUROPEAN PATENT SPECIFICATION

(45) Date of publication of patent specification: **07.01.87**

(51) Int. Cl.⁴: **G 09 B 23/18,** H 05 K 3/00,
H 01 L 21/00, H 05 K 13/00

(21) Application number: **81109398.8**

(22) Date of filing: **30.10.81**

(54) Method and apparatus to facilitate electronic circuit design, testing and manufacturing.

(30) Priority: **31.10.80 US 203387**

(43) Date of publication of application:
**12.05.82 Bulletin 82/19**

(45) Publication of the grant of the patent:
**07.01.87 Bulletin 87/02**

(84) Designated Contracting States:
**AT BE CH DE FR GB IT LI LU NL SE**

(56) References cited:
**DE-A-2 043 920**
**DE-A-2 147 068**
**FR-A-2 032 244**
**GB-A-2 033 128**
**US-A-3 510 963**

(73) Proprietor: **Hibbe, Ernst-Otto**
**Schwarzanger 21**
**D-8000 München (DE)**

(73) Proprietor: **Norrish, James D.**
**10105 Dogwood Avenue**
**Palm Beach Gardens Florida 33410 (US)**

(72) Inventor: **Hibbe, Ernst-Otto**
**Schwarzanger 21**
**D-8000 München (DE)**
Inventor: **Norrish, James D.**
**10105 Dogwood Avenue**
**Palm Beach Gardens Florida 33410 (US)**

(74) Representative: **von Kirschbaum, Albrecht, Dipl.-Ing.**
**Hermann-Ehlers-Strasse 21a**
**D-8034 Germering (DE)**

Courier Press, Leamington Spa, England.

## Description

### Background of the Invention
#### Field of the Invention

The present invention relates to electronic circuit design, testing and manufacturing, and more particularly pertains to a method and apparatus for designing, testing and manufacturing electronic circuits, such as integrated circuits, and printed circuit boards, through the use of a breadboard having an electronic component layout on one side with the matching electronic components fixedly and electrically secured to the other side.

### Description of the Prior Art

In the field of electronic circuit testing, design and construction, it is well-known to utilize breadboards to patch a plurality of electronic components, such as transistors, diodes, resistors, etc., together into an electrical circuit configuration. In this respect, it is typical practice to first design a circuit on a piece of paper and then to reconstruct the same with the actual components illustrated in the designed circuit on the aforedescribed breadboard. This, of course, is a cumbersome and time-consuming process due to the necessity of locating the specific desired components possessing the required parameters and further, many of these components are typically out of tolerance to the extent that errors and inaccuracies are introduced into the designed circuit. As such, there has existed a continuing need for both improved methods and devices which facilitate integrated and other electronic circuit design.

In this connection, one approach has been to provide breadboards having the electronic components fixedly secured on one surface thereof while an electronic component layout is provided on the other surface so as to provide a user with the ability to make a rapid determination of the types of electronic components provided along with their respective parameters and tolerances. As such, a user could quickly utilize patch cords or similar connection means to electrically interconnect the various electronic components in a desired circuit configuration. Such a breadboard is illustrated in U.S. Des. patent 225,532, issued December 19, 1972, to Flynn et al., wherein there is illustrated a solid state logic learning center which includes the use of a breadboard having a plurality of electronic components fixedly secured to one surface and selectively electrically connectible together through the use of patch cords, and a circuit component layout imprinted on the other surface to facilitate a proper interconnecting of the various components. While the construction of the breadboard illustrated in the Flynn et al patent could greatly reduce the time involved in designing a logic circuit, such as during a training exercise, no means are provided to facilitate a quick transfer of the designed circuit to a separate piece of paper whereby a permanent record of the circuit is maintained once the patch cords are removed from the breadboard. Accordingly, a user must still go through the tedious and time-consuming process of drawing the patched electronic circuit if he wishes to permanently maintain a record thereof.

As with the Flynn et al device, there has also been provided a number of other devices which employ electronic component layouts or schematics along with their associated components on breadboards. For example, U.S. patent No. 3,842,517, issued October 22, 1974 to La Chance, illustrates an apparatus in the form of a box-shaped enclosure having a predetermined circuit diagram including test points illustrated on a front portion thereof and containing the actual wired circuit within the enclosure. A switch array is provided to connect various points in the circuit, and one or more of the switches may be moved to a fault position for introducing a fault condition to the circuit for the purpose of training electronic personnel in circuit repair. However, the breadboard of La Chance is not utilized for the purpose of designing or manufacturing circuits, nor are there any means provided to permanently record a particular circuit design, if desired.

Similarly, in U.S. patent No. 3,728,534, issued April 17, 1973, to Bertram, et al, there is illustrated a constructable logic system which includes a schematic of a plurality of logic components and an array of switches and connectors for providing the desired inputs to and connections between the various components. As such, the Bertram et al apparatus may be used to design and test a particular logic circuit; however, again no means are provided for permanently recording the designed circuit. Therefore, it is to be recognized that a need still exists for improving both the methods and devices utilized in designing, testing and manufacturing electronic circuits whereby the same might be quickly and easily permanently recorded once a particular design has been achieved. This need is substantially met by the construction of the method and apparatus of the present invention.

### Summary of the Invention

The general purpose of the present invention is to provide a method and apparatus for designing, permanently recording, testing and manufacturing electronic circuits, such as integrated circuits and printed circuit boards, and which has all the advantages of the similarly employed prior art devices and methods, and none of the disadvantages. To attain this, according to the present invention, a parchment is provided which is essentially a duplicate component layout representation of the electronic circuit components associated with the known breadboard, so that a user may permanently record a particular designed circuit onto the parchment. In this respect, a user need only to patch a particular electronic circuit on the known breadboard and then use a pencil or similar marking instrument to illustrate the patched connections between the components on the parchment. The parchment may then be forwarded to a manufacturer for the manufacture of an appropriate integrated circuit of printed circuit board. In this connection, the parchment is provided with a plurality of broken guide lines so as to facilitate a user's drawing of the leads between particular electronic components, such guide lines representing the design requirements such as spacing, positioning, etc., required to manufacture the integrated circuit or printed circuit board. As such, a user may effectively design the integrated circuit or printed circuit board without any necessity of redesign on the part of the manufacturer due to the crossing of lead connections, or the like.

It is therefore an object of the present invention to provide a method and apparatus for designing, permanently recording, testing, and manufacturing electronic circuits, such as integrated circuits, and printed circuit boards which has all of the advantages of the prior art devices and methods none of the disadvantages.

It is another object of the present invention to provide a means and method for both designing and recording an electronic circuit in one simple and quick operation.

It is a further object of the present invention to substantially reduce the time required in constructing a breadboard electronic circuit.

Still another object of the present invention is to provide a device which may be utilized to teach electronic circuit design.

Yet another object of the present invention is to provide a device which may be utilized for in-circuit evaluation of components within existing external electronic circuits.

Even another object of the present invention is to substantially reduce the hardware construction problems associated with circuit breadboard implementation.

A still further object of the present invention is to provide a means and method for quick evaluation, iteration and design checking of an electronic circuit.

Even another object of the present invention is to provide a device which minimizes the errors and variations in tolerances associated with wiring, soldering and wrapping an electronic circuit.

Still even another object of the present invention is to provide an easy and economical method of ordering and having manufactured a particular integrated circuit or printed circuit board.

An even further object of the present invention is to provide a device which facilitates electronic circuit design and testing through the use of a built-in tester which may be utilized to quickly confirm the operability of associated electronic components.

These together with other objects and advantages which will become subsequently apparent reside in the details of construction and operation as more fully hereinafter described and claimed, reference being had to the accompanying drawings forming a part hereof, wherein like numerals refer to like parts throughout.

## Brief Description of the Drawings

Figure 1 is a top plan view of a portion of a parchment associated with the present invention and partially illustrating a typical electronic circuit component layout thereon;

Figure 2 is a top plan view of a portion of the breadboard of the present invention illustrating an electrical circuit component layout thereon analogous to the layout shown on the parchment of Fig. 1;

Figure 3 is a bottom plan view of the electronic components operably connected to a portion of the breadboard illustrated in Fig. 2;

Figure 4 is a side elevational view, partly in section, taken along the line 4—4 of Fig. 2.

## Description of the Preferred Embodiment

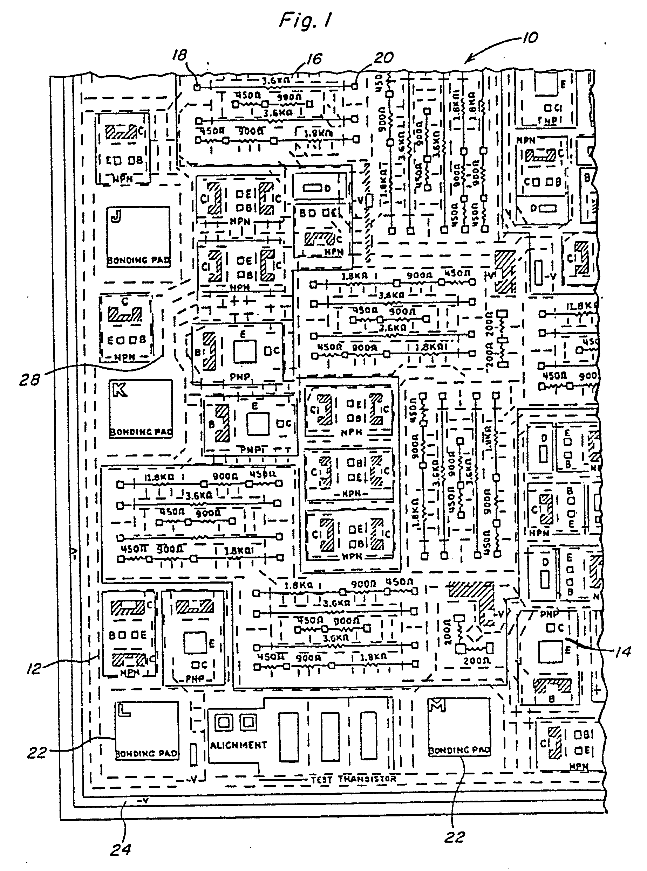

Reference is now made to the drawings and in particular to Fig. 1 wherein there is illustrated a parchment forming a part of the present invention and generally designated by the reference numeral 10. In this respect, the parchment 10 is illustrated as having a plurality of electronic components illustrated thereon, such components not being electrically interconnected. As can be appreciated, many different types of electronic components might be shown on the parchment 10, such as NPN, NPN power, Schottky and PNP transistors, resistors, diodes, logic gates, etc. For example, an NPN transistor 12 may be illustrated and may include the letters C, E and B at appropriate points relative thereto to illustrate the collector, emitter and base connection leads. Similarly, a PNP transistor 14 might be illustrated, as well as various resistors, such as resistor 16 which in the illustrated case is a 3,600 Ohm resistor. Additionally, small blocks may be drawn relative to the various electronic components to illustrate the proper points for electrically connecting the same, such as blocks 18, 20 associated with the resistor 16.

Also illustrated on the parchment 10 are a plurality of variously lettered bonding pads 22, which in an actual circuit would represent the points at which external connectors could be provided to an electronic circuit. An exterior rail 24 is diagrammatically illustrated on the parchment 10, such rail also serving as a point whereby external connectors and devices may be electrically associated with the electronic components illustrated on the parchment. As is apparent with reference to the parchment 10 shown in Fig. 1, the potential combinations of electronic components and their respective positioning is of an infinite number, and typically, computer design techniques may be employed to produce any number of desired circuit component layouts which may then be reproduced on a parchment as shown.

Further illustrated in Fig. 1 is the use of a plurality of broken lines 28 which effectively define the borders of the various electronic components, as well as defining desired electrical connection paths between the various components. In this regard, the parchment 10 effectively serves as a worksheet on which a plurality of electronic components are illustrated in an electrically disconnected configuration, and the broken lines 28 may be drawn over by a pencil or similar marking instrument to effectively illustrate a desired electrical connection between selected components. The lines 28 are representative of the design positioning of integrated circuit or printed circuit board connections between the components illustrated on the parchment 10 and as such, these broken lines, if utilized by a designer, represent preferred electrical connection paths between the components in the manufacture of an integrated circuit or printed circuit board. Accordingly, if these broken lines 28 are utilized to indicate the electrical connections between the various components, an integrated circuit or printed circuit board may be manufactured directly from reference to the parchment 10 without any substantial concern regarding short circuits and similar errors associated with the electrical interconnections.

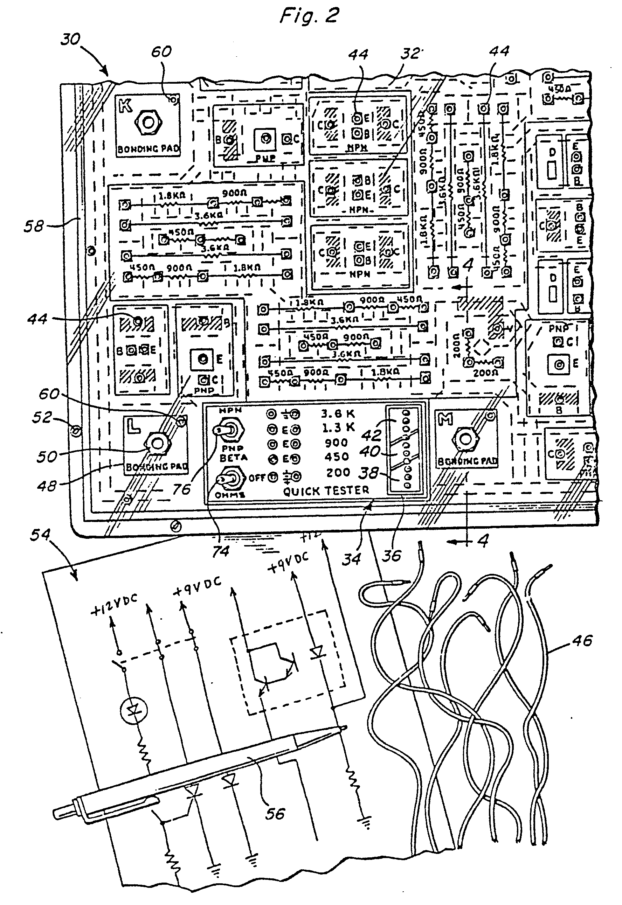

Fig. 2 illustrates a portion of a patchboard or breadboard 30 forming a part of the present invention, such breadboard including a topmost surface 32 onto which an electronic circuit component layout is inscribed by photoprocessing and silkscreening or other similar process. In this respect, it will be noted that the circuit component layout illustrated on the surface 32 of the breadboard 30 essentially conforms to the circuit component layout illustrated on the parchment 10 of Fig. 1, with the exception of the quick tester 34 shown in Fig. 2. As such, the parchment 10 is substantially a complete electronic component representation of the circuit component layout provided on the breadboard 30. As to the construction of the quick tester 34, the same enables a user to measure beta, resistor values, shorts, opens and battery power prior to or during a circuit hookup. In this respect, operation may be either by battery or an external power supply, and further, the quick tester 34 may employ a light emitting diode (LED) display 36 to indicate the test values of the particular components. In this connection, the LED display 36 may be divided into an unacceptable value range as indicated by the portion of the display 38, an acceptable value range as indicated by numeral 40, and a very good value range as indicated by the numeral 42. In the event that an unacceptable value is indicated, some or all of those light emitting diodes contained within the portion 38 will be functional, while if an acceptable value is indicated, all of the light emitting diodes within the portion 38 as well as some or all of the diodes within the portion 40 will operate. Similarly, if a very good value is indicated, all of the light emitting diodes within the portions 38, 40 will be functional along with some or all of the diodes contained within the portion 42.

Fig. 2 also serves to illustrate a plurality of electrical connection apertures or pin connections 44 into which appropriate connection wires or the like may be inserted to effect the electrical interconnection of various components. In this regard, the connection apertures 44 are positioned at points defined by the connection blocks, such as blocks 18, 20 shown on the parchment 10 in Fig. 1, and are of a conventional construction whereby the electrical leads, such as patch cords 46, may be directed through the topmost surface 32 of the breadboard into electrical communication with circuit components fixably a part of a bottommost portion of the breadboard.

While the patch cords 46 are utilizable to interconnect the various electronic components through the connection apertures 44, the bonding pads 48, which are analogous to the bonding pads 22 of the parchment 10, are illustrated as having larger connection apertures 50 fixedly positioned relative thereto. In this connection, the appertures 50 are of a conventional design and serve to facilitate the receipt of external jacks therein so as to permit an electrical interconnection between the breadboard 30 and an electrical electronic circuit.

Also illustrated in Fig. 2 are connection means, such as screws 52 or the like, which are employable to attach the topmost surface portion 32 of the breadboard 30 to a supporting structure. Further, the method of the present invention is made more clear by noting the use of a roughly drawn electronic circuit 54, by the use of a pen 56 or the like, whereby it is implied that a user might first roughly design a circuit and then might employ the patch cords 46 to interconnect components on the breadboard 30 which are analogous to the components illustrated in the drawn circuit 54. In this respect, the various DC voltage sources as illustrated in the drawn circuit 54 might be supplied from an external source or alternatively, such power supplies might be provided within the breadboard 30 if such is desired. Further, external power sources might be supplied through the use of an exterior electrical connection rail 58, such rail being analogous to the exterior rail 24 of the parchment 10, while other signals or power supplies may be directed to the breadboard 30 through respective jacks 50 having takeoff connection apertures 60 associated therewith. In this regard, the apertures 60 are identical in construction to the apertures 44 so that the patch cords 46 may be effectively interconnected therebetween.

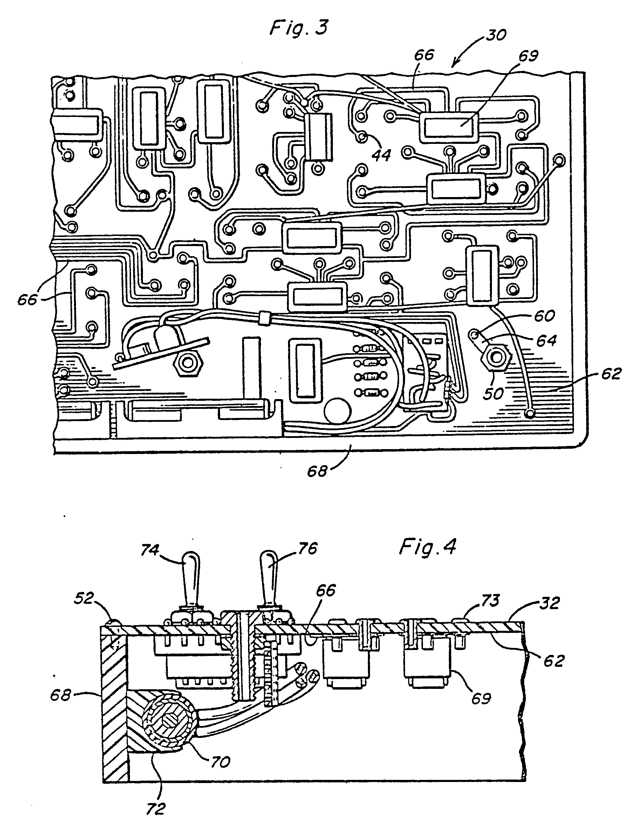

Fig. 3 illustrates a partial bottom plan view of the breadboard 30 shown in Fig. 2. In this regard, the numbered jack 50 as shown in Fig. 2 and having the letter "L" inscribed proximate thereto is shown extending through a bottommost surface 62 of the breadboard. As shown, the associated connection aperture 60 is electrically connected to the jack 50 by means of a solder lead 64. Similarly, a plurality of solder leads 66 are variously directed along the bottommost surface 62 of the breadboard 30 so as to effect the various desired electrical connections between connection apertures 44 an associated electronic components, such as transistors 69. Essentially then Fig. 3 serves to illustrate the fact that all of the various electrical components, as illustrated on the topmost surface 32 of the breadboard 30, as well as on the parchment 10, are actually provided on the bottommost portion 62 of the breadboard. Further, if can be appreciated that each of the apertures 44 extend all the way through the breadboard 30 so that when the patch cords 46 are inserted within the apertures from the topmost surface 32 side of the breadboard, they will extend outwardly from the bottommost portion 62 so as to be in electrical communication with the solder leads 64 serving to electrically connect the same to the electronic components.

Viewing Fig. 3 in combination with Fig. 4, which is a sectional view taken along the lines 4—4 of Fig. 2, it can be seen that the breadboard 30 includes sidewalls 68 which serve to protect the electronic components mounted on the bottommost portion 62 thereof, and further may include an internal power supply, such as batteries 70, or the like. In this regard, the batteries 70 may be fixedly secured to a respective sidewall 68 through the use of a mounting member 72. Additionally, Fig. 4 illustrates the fact that the topmost portion or surface 32 of the breadboard 30 is essentially flat in construction, having only extensions 73 projecting upwardly therefrom which are associated with the respective connection apertures 44, 60, since the electronic circuit component layout illustrated in Figs. 1 and 2 is printed thereon through photoprocessing and silkscreening, or similar process, and is thus not visible in a side view. Additionally shown are the toggle switches 74, 76 associated with the quick tester 34, as well as the fact that the various electronic components, such as transistors 69 extend below the bottommost surface 62 of the breadboard while being fixedly secured thereto. Effectively then, the sidewalls 68 serve to prevent a direct contact between the various electronic components and a supporting surface, thereby preventing damage to the same.

In performing the method associated with the apparatus of the present invention, it can be appreciated with reference to Fig. 2 that a user might first design a circuit, such as the roughly illustrated circuit 54, and then might utilize the patch cords 46 to construct the drawn circuit 54 on the breadboard 30. In this respect, a user might test all of the electronic components to be employed by means of utilizing the quick tester 34 so as to insure the proper functioning of each individual component. In this regard, the breadboard 30 may be utilized to insert the desired electronic components into an existing electronic circuit through use of the various connection jacks 50 or through use of the exterior connection rail 58. At this point of the operation, it is immaterial whether a designed circuit is being tested for its operability or whether components in an existing circuit are being bypassed for the purpose of testing the same. Assuming, however, that a designed circuit is being tested and that the circuit performs the desired operation, a user may wish to keep a permanent diagram of the circuit other than his roughly drawn notes and schematics and this may be accomplished through use of the parchment 10 illustrated in Fig. 1. In this respect, the parchment 10 has a substantially identical electronic circuit component layout to that shown on the breadboard 30 of Fig. 2, so that a user need only to employ a pen or pencil 56 to draw connection leads between the various boxes, such as boxes 18 and 20 associated with the resistor 16, to indicate the desired electrical connections. Further, in the event that a user may desire to have an integrated circuit or printed circuit board manufactured which incorporates the construction of his designed circuit, use may be made of the broken lines 28 over which a pencil may be traced to indicate the desired electrical connections. The broken lines 28 represent the desired positioning of electrical connection leads on a manufactured integrated circuit or printed circuit board so as to minimize short circuits, electrical interference, etc., during and after the manufacture of the integrated circuit or printed circuit board.

Once a user has completely designed his circuit by tracing out the same on the parchment 10, the parchment may be forwarded to a manufacturer and an integrated circuit or printed circuit board employing the design may be manufactured. The costs of such manufacture are minimized through the use of the broken lines 28 since there is no necessity on the part of the manufacturer to substantially alter the indicated layout of the various electrical connection leads between the desired components. In this connection, it is anticipated that the present invention will be provided with both a parchment and the associated breadboard during a marketing thereof, and further, manufacturers may be provided with similar parchments, breadboards and related information to facilitate an easy and economical manufacture thereof in response to a designer's request.

As can be appreciated, in most instances a user will have available a diagram of an electronic circuit which defines the individual electronic components, and a particular parchment 10 may be selected based upon the number and type of components available. As such, a user can quickly and easily convert a theoretical schematic into a working circuit without having to construct a mechanical fixture, and the user should be able to determine whether his circuit functions in one-fifth or less time than it would take him to construct a conventional breadboard to determine whether the circuit works. Accordingly, quick circuit design and breadboarding is facilitated, as is black box testing, in-circuit evaluation, and integrated circuit and printed circuit board manufacturing. Further, the present invention can be utilized as a means for testing circuit performance by employing selectively removable electronic components which may have various tolerances and parameters. For example, transistors with current gains from 100 to 300 or resistors having tolerances from −20% to +20% of the nominal value can be substituted as desired. With respect to the parchment 10 illustrated in Fig. 1, the electronic component layout printed thereon represents one of a plurality of available component arrangements. In this respect, the electronic component layout shown in Fig. 1 is but one of 20 different embodiments currently available, which include 13 analog, 4 digital and 3 analog/digital configurations, while a plurality of additional configurations are now in the design process. Additionally, the present invention may utilize color coding to identify the electronic components, both on the parchment and the breadboard per se, such color coding confirming therebetween to facilitate the interrelated use of the parchment and breadboard. Further, the invention may be provided with spare components, while the separate exterior rail 58 for external component attachment is provided so that no external components need to be used inside of the rail. The breadboard 30 may further be provided with plug-in integrated circuit sockets for easy removal of components, while spare components may be attached to an underside of the breadboard.

With respect then to the above described method and apparatus forming the present invention, it is to be understood that the optimum dimensional relationship of the parts of the invention are deemed readily apparent and obvious to one skilled in the art, and all equivalent relationships to those illustrated in the drawings and described in the specification are intended to be encompassed by the invention. For example, it is to be understood that the electronic component layout illustrated both in Figs. 1 and 2 represents only a portion of the present invention and that a typical embodiment thereof may employ six hundred or more pin connections 44 along with associated electronic components. Further, it is understood that the breadboard 30 might be substantially altered in size and design so as to permit a variation in components employed resulting in various sizes of parchments and breadboards. Also, the circuit tester 34 may be positioned outside of the exterior rail 58.

## Claims

1. An apparatus for use in designing, testing and manufacturing electronic circuits, said apparatus having patchboard means (30) having a plurality of electronic components (such as 69) fixedly secured thereto, connection means (46) operably associated with said patchboard means (30) for facilitating a selective interconnection of said electronic components (69) into electrical communication with one another, and identification means operably associated with said patchboard means (30) to facilitate an identification of said electronic components, characterized by recording means (10) including a parchment means (10) having a second electronic component layout illustrated thereon, whereby the second electronic component layout of said parchment means (10) is substantially identical in design to said electronic component layout provided on said one surface (32) of said patchboard means (30), for maintaining a record of a particular electronic circuit designed and manufactured through the use of said apparatus.

2. The apparatus for use in designing, testing and manufacturing electronic circuits as defined in claim 1, wherein said patchboard means includes a breadboard (30) having a plurality of electrical connection apertures (44) positioned therein, said electrical connection apertures (44) being operable to receive electrical connectors (46) therein to facilitate said interconnection of said electronic components.

3. The apparatus for use in designing, testing and manufacturing electronic circuits as defined in claim 2, wherein said connection means includes a plurality of electrical connectors (64, 66) fixedly attached to said patchboard means (30) so as to facilitate the selective interconnection of said electronic components (such as 69) through the use of separable electrical connectors (46).

4. The apparatus for use in designing, testing and manufacturing electronic circuits as defined in claim 3, wherein said identification means includes an electronic component layout on one surface (32) of said patchboard means (30), said electronic component layout (32) serving to identify respective ones of said electronic components.

5. The apparatus for use in designing, testing and manufacturing electronic circuits as defined in claim 4, wherein said respective ones of said electronic components (such as 69) are fixedly secured to a second surface (62) of said patchboard means (30) and are positioned proximate to said electronic component layout (32) whereby each respective electronic component is substantially identified as to location on said patchboard means (30).

6. The apparatus for use in designing, testing and manufacturing electronic circuits as defined in any one of claims 1 to 4 wherein said electrical connectors fixedly attached to said patchboard means (30) include solder leads (64, 66) positioned between said connection apertures (60) and said respective electronic components whereby said separable electrical connectors (46) may be directed into electrical communication with said electronic components by connecting the same to said connection apertures (60).

7. The apparatus for use in designing, testing and manufacturing electronic circuits as defined in claim 6, wherein said separable electrical connectors comprise patch cords (46).

8. The apparatus for use in designing, testing and manufacturing electronic circuits as defined in claim 7, and further wherein said electrical connectors (46) fixedly attached to said patchboard means (30) may include electrical wires attached between respective ones of said electrical connection apertures (60) and said electronic components.

9. The apparatus for use in designing, testing and manufacturing electronic circuits as defined in claim 1 wherein said parchment means (10) is provided with interconnection directing means (28) so as to facilitate a recording of said particular electronic circuit (54) on said recording means (10) and further to facilitate a manufacturing of an integrated circuit or printed circuit board from said recording means (10).

10. The apparatus for use in designing, testing and manufacturing electronic circuits as defined in claim 9, wherein said interconnection directing means includes a plurality of broken lines (28) printed on said parchment means (10), said broken lines indicating desired connection paths between respective ones of said electronic components and (such as 69) being positioned relative to one another whereby no short circuits or electrical interference would exist in an integrated circuit or printed circuit board manufactured in compliance with a designed circuit on said parchment (10) means.

11. The apparatus for use in designing, testing and manufacturing electronic circuits as defined in claim 1, wherein said patchboard means (30) is further provided with a circuit test means (34) so as to assure that said electronic components are operable within prescribed parameters.

12. The apparatus for use in designing, testing and manufacturing electronic circuits as defined in claim 11, wherein said circuit test means (34) further includes a light emitting diode display (36) to indicate whether respective ones of said electronic components (such as 69) are operating within desired parameters.

13. The apparatus for use in designing, testing and manufacturing electronic circuits as defined in claim 11, wherein said circuit test means (34) further includes a means (76) for testing the operability of transistors within desired parameters.

14. The apparatus for use in designing, testing and manufacturing electronic circuits as defined in claim 11, wherein said circuit test means (34) further includes means for testing the electrical power provided to said electronic components.

15. The apparatus for use in designing, testing and manufacturing electronic circuits as defined in claim 11, wherein said circuit test means (34) further includes means (74) for testing resistor values associated with resistors forming a portion of said electronic components.

16. The apparatus for use. in designing, testing and manufacturing electronic circuits as defined in claim 1, wherein said patchboard means (30) is further provided with bonding pads (48), said bonding pads (48) serving as connection points between external circuits and devices and said patchboard means (30).

17. The apparatus for use in designing, testing and manufacturing electronic circuits as defined in claim 1, wherein said patchboard means (30) further includes an exterior circuit connection rail (58) so as to facilitate a connection between external circuits and devices and said patchboard means (30).

18. The apparatus for use in designing, testing and manufacturing electronic circuits as defined in claim 1, wherein said patchboard means (30) further includes a power supply means (70) for driving respective ones of said electronic components associated with said patchboard means (30).

19. The apparatus for use in designing, testing and manufacturing electronic circuits as defined in claim 18, wherein said power supply means includes the use of internally positioned batteries (70).

20. The apparatus for use in designing, testing and manufacturing electronic circuits as defined in claim 1, and further wherein spare components may be provided in an interior portion of said apparatus.

21. The apparatus for use in designing, testing and manufacturing electronic circuits as defined in claim 1, wherein said electronic components are removably fixedly secured thereto so as to selectively permit a removal of individual ones of said electronic components and a replacement thereof with other electronic components of a similar construction.

22. The apparatus for use in designing, testing and manufacturing electronic circuits as defined in claim 1, wherein said identification means (28) is color coded to facilitate an easy identification of respective ones of said electronic components.

23. The apparatus for use in designing, testing and manufacturing electronic circuits as defined in claim 22, wherein said parchment (10) is color coded in an identical manner to a color coding of said identification means (28) so as to further facilitate an identification of respective ones of said electronic components between said patchboard means (30) and said parchment means (10).

24. A method of constructing an apparatus for use in designing, testing and manufacturing electronic circuits, said method including the steps of fixedly attaching a plurality of electronic components (such as 69) to one side (62) of a patchboard (30), identifying said plurality of electronic components through a use of an electronic component layout on another side (32) of said patchboard (30), providing a means (46) for interconnecting respective ones of said electronic components of said patchboard so as to facilitate a completed designed electronic circuit; characterized by providing a parchment means (10) having a second electronic component layout imprinted thereon, said second electronic component layout being substantially an identical representation of said electronic component layout positioned on said patchboard (10), whereby said second electronic component layout may be utilized to separately illustrate and permanently record a particular electronic circuit (such as 54) which may be constructed on said patchboard (30).

25. The method for constructing an apparatus for use in designing, testing and manufacturing electronic circuits as defined in claim 24, and further including the step of providing circuit test means (34) in combination with said patchboard (30) so as to facilitate a selective testing of said electronic components (69).

26. The method for designing, testing and manufacturing electronic circuits as defined in claim 24 and further including the step of providing broken guide lines (28) between respective ones of said electronic components on said parchment (10) so as to facilitate a marking of desired connections between said electronic components.

27. The method for designing, testing and manufacturing electronic circuits as defined in claim 26, and further including the step of positioning said guide lines in a manner whereby an integrated circuit or printed circuit board may be manufactured from said parchment (10) including the positioning of electrical connection leads over said broken lines (28) which have markings thereon without any substantial concern regarding short circuits and electrical interference.

28. The method for designing, testing and manufacturing electronic circuits as defined in claim 26, and further including the step of utilizing said parchment (10) having said electronic circuit permanently recorded thereon to manufacture an integrated circuit or printed circuit board.

**Revendications**

1. Dispositif destiné à être utilisé pour dessiner, essayer et fabriquer des circuits électroniques, ledit dispositif possédant des moyens formant plaque de montage (30) comportant un ensemble de composants électroniques (tel que 69) solidarisés sur elle, des moyens de connexion (46) associés fonctionnellement auxdits moyens formant plaque de montage (30) pour faciliter une interconnexion sélective desdits composants électroniques (69) en communication électrique les uns avec les autres, et des moyens d'identification associés fonctionnellement auxdits moyens formant plaque de montage (30) pour faciliter l'identification desdits composants électroniques, caractérisé par des moyens d'enregistrement (10) comprenant des moyens formant parchemin (10) sur lesquels est représenté un second schéma d'implantation des composants électroniques, le second schéma d'implantation des composants électroniques desdits moyens formant parchemin (10) étant sensiblement identique dans son dessin audit schéma d'implantation des composants électroniques prévu sur ladite première surface (32) des moyens formant plaque de montage (30) en vue de conserver un enregistrement d'un circuit électronique particulier dessiné et fabriqué en utilisant ledit dispositif.

2. Dispositif destiné à être utilisé pour dessiner, essayer et fabriquer des circuits électroniques selon la revendication 1, dans lequel lesdits moyens formant plaque de montage comprennent une plaque de montage expérimental (30) comportant un ensemble d'ouvertures de connexion électrique (44) positionnées sur lui, lesdites ouvertures de connexion électrique (44) étant aptes à recevoir des connecteurs électriques (46) pour faciliter ladite interconnexion desdits composants électroniques.

3. Dispositif destiné à être utilisé pour dessiner, essayer et fabriquer des circuits électroniques selon la revendication 2, dans lequel lesdits moyens de connexion comprennent un ensemble de connecteurs électriques (64, 66) solidaires desdits moyens formant plaque de montage (30) de manière à faciliter l'interconnexion sélective desdits composants électroniques (tels que 69) par l'utilisation de connecteurs électriques séparables (46).

4. Dispositif destiné à être utilisé pour dessiner, essayer et fabriquer des circuits électroniques selon la revendication 3, dans lequel lesdits moyens d'identification comprennent un schéma d'implantation des composants électroniques sur une première surface (32) desdits moyens formant plaque de montage (30), ledit schéma d'implantation des composants électroniques (32) servant à identifier certains respectifs desdits composants électroniques.

5. Dispositif destiné à être utilisé pour dessiner, essayer et fabriquer des circuits électroniques selon la revendication 4, dans lequel lesdits composants électroniques respectifs (tels que 69) sont fermement fixés à une seconde surface (62) desdits moyens formant plaque de montage (30) et sont disposés directement sur ledit schéma d'implantation des composants électroniques (32), ce grâce à quoi chaque composant électronique respectif est sensiblement identifié en ce qui concerne son emplacement sur lesdits moyens formant plaque de montage (30).

6. Dispositif destiné à être utilisé pour dessiner, essayer et fabriquer des circuits électroniques selon l'une quelconque des revendications 1 à 4, dans lequel lesdits connecteurs électriques solidarisés auxdits moyens formant plaque de montage (30) comprennent des conducteurs à souder (64, 66) disposés entre lesdites ouvertures de connexion (60) et lesdits composants électroniques respectifs, ce grâce à quoi lesdits connecteurs électriques séparables (46) peuvent être mis en communication électrique avec lesdits composants électroniques en les reliant auxdites ouvertures de connexion (60).

7. Dispositif destiné à être utilisé pour dessiner, essayer et fabriquer des circuits électroniques selon la revendication 6, dans lequel lesdits connecteurs électriques séparables comprennent des cordons de montage (46).

8. Dispositif destiné à être utilisé pour dessiner, essayer et fabriquer des circuits électroniques selon la revendication 7, et en outre dans lequel lesdits connecteurs électriques (46) solidarisés auxdits moyens formant plaque de montage (30) peuvent comprendre des fils électriques fixés entre certaines respectives des ouvertures de connexion électriques (60) et lesdits composants électroniques.

9. Dispositif destiné à être utilisé pour dessiner, essayer et fabriquer des circuits électroniques selon la revendication 1, dans lequel lesdits moyens formant parchemin (10) sont munis de moyens d'indication d'interconnexion (28) pour faciliter l'enregistrement dudit circuit électronique particulier (54) sur lesdits moyens d'enregistrement et pour faciliter en outre une fabrication d'un circuit intégré ou d'une plaquette à circuits imprimés à partir desdits moyens d'enregistrement (10).

10. Dispositif destiné à être utilisé pour dessiner, essayer et fabriquer des circuits électroniques selon la revendication 9, dans lequel lesdits moyens d'indication d'interconnexion comprennent un ensemble de lignes interrompues (28) imprimées sur lesdits moyens formant parchemin (10), lesdites lignes interrompues indiquant des parcours de connexion désirés entre certains respectifs desdits composants électroniques (tel que 69) et étant disposées les unes par rapport aux autres de manière que des court-circuits ou des interférences électriques ne puissent pas exister dans un circuit intégré ou une plaquette à circuits imprimés fabriqué conformément à un circuit dessiné sur lesdits moyens formant parchemin (10).

11. Dispositif destiné à être utilisé pour dessiner, essayer et fabriquer des circuits électroniques selon la revendication 1, dans lequel lesdits moyens formant parchemin (30) sont munis en outre de moyens d'essai de circuit (34) de manière à être certain que lesdits composants électroniques peuvent fonctionner dans les limites de paramètres prescrits.

12. Dispositif destiné à être utilisé pour dessiner, essayer et fabriquer des circuits électroniques selon la revendication 11, dans lequel lesdits moyens d'essai de circuit (34) comprennent en outre un affichage à diodes émettrices de lumière (36) pour indiquer si certains respectifs des composants électroniques (tel que 69) fonctionnent dans les limites desdits paramètres désirés.

13. Dispositif destiné à être utilisé pour dessiner, essayer et fabriquer des circuits électroniques selon la revendication 11, dans lequel lesdits moyens d'essai de circuit (34) comprennent en outre des moyens (76) pour tester la possibilité de fonctionnement de transistors dans les limites desdits paramètres désirés.

14. Dispositif destiné à être utilisé pour dessiner, essayer et fabriquer des circuits électroniques selon la revendication 11, dans lequel lesdits moyens d'essai de circuit (34) comprennent en outre des moyens pour essayer la puissance électrique appliquée auxdits composants électroniques.

15. Dispositif destiné à être utilisé pour dessiner, essayer et fabriquer des circuits électroniques selon la revendication 11, dans lequel lesdits moyens d'essai de circuit (34) comprennent en outre des moyens (74) pour tester les valeurs de résistance associées aux résistances formant une partie desdits composants électroniques.

16. Dispositif destiné à être utilisé pour dessiner, essayer et fabriquer des circuits électroniques selon la revendication 1, dans lequel lesdits moyens formant plaque de montage (30) sont munis en outre d'éléments de liaison (48), ces éléments de liaison (48) servant de points de connexion entre des circuits et des dispositifs externes et lesdits moyens formant plaque de montage (30).

17. Dispositif destiné à être utilisé pour dessiner, essayer et fabriquer des circuits électroniques selon la revendication 1, dans lequel lesdits moyens formant plaque de montage (30) comprennent en outre un rail de connexion (58) pour circuits extérieurs pour faciliter une connexion entre des circuits et des dispositifs extérieurs et lesdits moyens formant plaque de montage (30).

18. Dispositif destiné à être utilisé pour dessiner, essayer et fabriquer des circuits électroniques selon la revendication 1, dans lequel lesdits moyens formant plaque de montage (30) comprennent en outre des moyens d'alimentation de puissance (70) pour exciter certains respectifs desdits composants électroniques associés auxdits moyens formant plaque de montage (30).

19. Dispositif destiné à être utilisé pour dessiner, essayer et fabriquer des circuits électroniques selon la revendication 18, dans lequel lesdits moyens d'alimentation de puissance comprennent l'utilisation de batteries (70) montées à l'intérieur.

20. Dispositif destiné à être utilisé pour dessiner, essayer et fabriquer des circuits électroniques selon la revendication 1, et dans lequel en outre des composants de rechange peuvent être prévus dans une partie interne dudit dispositif.

21. Dispositif destiné à être utilisé pour dessiner, essayer et fabriquer des circuits électroniques selon la revendication 1, dans lequel lesdits composants électroniques sont solidarisés de façon amovible, de manière à permettre sélectivement un retrait de certains desdits composants électroniques et leur remplacement par d'autres composants électroniques de construction similaire.

22. Dispositif destiné à être utilisé pour dessiner, essayer et fabriquer des circuits électroniques selon la revendication 1, dans lequel lesdits moyens d'identification (28) sont codés en couleur pour faciliter une identification aisée de certains respectifs desdits composants électroniques.

23. Dispositif destiné à être utilisé pour dessiner, essayer et fabriquer des circuits électroniques selon la revendication 22, dans lequel ledit parchemin (10) est codé en couleur d'une manière identique à un codage en couleur desdits moyens d'identification (28) pour faciliter encore plus une identification de certains respectifs desdits composants électroniques entre lesdits moyens formant plaque de montage (30) et lesdits moyens formant parchemin (10).

24. Procédé pour construire un dispositif destiné à être utilisé pour dessiner, essayer et fabriquer des circuits électroniques, ledit procédé comprenant les étapes consistant à
solidariser un ensemble de composants électroniques (tel que 69) sur un premier côté (62) d'une plaque de montage (30),

identifier ledit ensemble de composants électroniques en utilisant un schéma d'implantation de composants électroniques sur un autre côté (32) de ladite plaque de montage (30),

prévoir des moyens (46) pour interconnecter certains respectifs desdits composants électroniques de ladite plaque de montage de manière à faciliter la réalisation d'un circuit électronique dessiné et terminé,

caractérisé en ce que l'on prévoit des moyens formant parchemin (10) sur lesquels sont imprimés un second schéma d'implantation de composants électroniques, ledit second schéma d'implantation de composants électroniques étant sensiblement une représentation identique dudit schéma d'implantation de composants électroniques disposé sur ladite plaque de montage (30), ce grâce à quoi ledit second schéma d'implantation de composants électroniques peut être utilisé pour illustrer séparément et conserver de façon permanente un circuit électronique particulier (tel que 54) qui peut être constitué sur ladite plaque de montage (30).

25. Procédé pour construire un dispositif destiné à être utilisé pour dessiner, essayer et fabriquer des circuits électroniques selon la revendication 24, et comprenant en outre l'étape consistant à prévoir des moyens d'essai de circuit (34) en combinaison avec ladite plaque de montage (30) pour faciliter un essai sélectif desdits composants électroniques (69).

26. Procédé pour dessiner, essayer et fabriquer des circuits électroniques selon la revendication 24, et comprenant en outre l'étape consistant à prévoir des lignes interrompues de guidage (28) entre certains respectifs desdits composants électroniques sur ledit parchemin (10) pour faciliter un marquage des connexions désirées entre lesdits composants électroniques.

27. Procédé pour dessiner, essayer et fabriquer des circuits électroniques selon la revendication 26, et comprenant en outre l'étape consistant à positionner lesdites lignes de guidage d'une manière telle qu'un circuit intégré ou une plaquette à circuits imprimés puisse être fabriqué à partir dudit parchemin (10), y compris le positionnement de conducteurs de liaison électriques sur lesdites lignes interrompues (28) qui portent des marques sans avoir essentiellement à tenir compte de court-circuits et d'interférences électriques.

28. Procédé pour dessiner, essayer et fabriquer des circuits électroniques selon la revendication 26, et comprenant en outre l'étape consistant à utiliser ledit parchemin (10) sur lequel est enregistré de façon permanente ledit circuit électronique pour fabriquer un circuit intégré ou une plaquette à circuits imprimés.

**Patentansprüche**

1. Apparatur zum vereinfachten Entwerfen, Prüfen und Herstellen einer elektronischen Schaltkreisanordnung,

mit einem Schaltbrett (30) mit einer Anzahl fest daran angebrachter elektronischer Bauelemente (wie 69),

mit Verbindungseinrichtungen (46), welche dem Schaltbrett (30) zugeordnet sind, um ein wahlweises Zusammenschalten der elektronischen Bauelemente (69) zu einer elektrischen Schaltung zu vereinfachen, und

mit einer Identifizierungseinrichtung, welche dem Schaltbrett (30) zugeordnet ist, um eine Identifizierung der elektronischen Bauelemente zu vereinfachen, gekennzeichnet durch

Aufzeichnungsmittel (10) in Form eines Bogen Pergaments (10) mit einem zweiten darauf dargestellten Anordnungsplan elektronischer Bauelemente, wobei der zweite Anordnungsplan auf dem Bogen Pergament (10) in der Auslegung genau identisch mit dem Anordnungsplan elektronischer Bauelemente ist, welcher auf der einen Seite (32) des Schaltbretts (30) vorgesehen ist, um eine Aufzeichnung einer speziellen elektroni-Schaltung zu erhalten, welche unter Zuhilfenahme der Apparatur ausgelegt und angefertigt worden ist.

2. Apparatur zum vereinfachten Entwerfen, Prüfen und Herstellen einer elektronischen Schaltkreisanordnung nach Anspruch 1, dadurch gekennzeichnet, daß das Schaltbrett eine Lochrasterplatte (30) mit einer Vielzahl darauf vorgesehener, elektrischer Anschlußöffnungen (44), zur Aufnahme elektrischer Verbindungsteile (46) aufweist, um das Zusammenschalten der elektronischen Bauelemente zu vereinfachen.

3. Apparatur zum vereinfachten Entwerfen, Prüfen und Herstellen einer elektronischen Schaltkreisanordnung nach Anspruch 2, dadurch gekennzeichnet, daß die Verbindungseinrichtung eine Anzahl elektrischer Anschluß- und Verbindungteile (64, 66) aufweist, die an dem Schaltbrett (30) fest angebracht sind, um so das wahlweise Zusammenschalten der elektronischen Bauelemente (wie 69) mit Hilfe von lösbaren elektrischen Verbindungsteilen (46) zu vereinfachen.

4. Apparatur zum vereinfachten Entwerfen, Prüfen und Herstellen einer elektronischen Schaltkreisanordnung nach Anspruch 3, dadurch gekennzeichnet, daß die Identifizierungseinrichtung einen Anordnungsplan elektronischer Bauelemente auf einer Seite (32) des Schaltbretts (30) aufweist, wobei der Anordnungsplan elektronischer Bauelemente dazu dient, die jeweiligen elektronischen Bauelemente zu identifizieren.

5. Apparatur zum vereinfachten Entwerfen, Prüfen und Herstellen einer elektronischen Schaltkreisanordnung nach Anspruch 4, dadurch gekennzeichnet, daß die jeweiligen elektronischen Bauelemente (wie 69) fest auf einer zweiten Seite (62) des Schaltbretts (30) angebracht sind, und unmittelbar bei dem Anordnungsplan für elektronische Bauelemente angeordnet sind, wodurch jedes elektronische Bauelement bezüglich seiner Lage auf dem Schaltbrett (30) genau identifiziert ist.

6. Apparatur zum vereinfachten Entwerfen, Prüfen und Herstellen einer elektronischen Schaltkreisanordnung nach einem der Ansprüche 1 bis 4, dadurch gekennzeichnet, daß die elektrischen Anschluß- und Verbindungsteile, die fest an dem Schaltbrett (30) angebracht sind, Leitungen (64, 66) aus Lötzinn aufweisen, welche zwischen den Anschlußöffnungen (60) und den jeweiligen elektronischen Bauelementen angeordnet sind, so daß die lösbaren elektrischen Verbindungsteile (46) in elektrische Verbindung mit den elektronischen Bauelementen gebracht werden können, indem diese mit den Anschlußöffnungen (60) verbunden werden.

7. Apparatur zum vereinfachten Entwerfen, Prüfen und Herstellen einer elektronischen Schaltkreisanordnung nach Anspruch 6, dadurch gekennzeichnet, daß die lösbaren elektrischen Verbindungsteile steckbare Verbindungen (46) aufweisen.

8. Apparatur zum vereinfachten Entwerfen, Prüfen und Herstellen einer elektronischen Schaltkreisanordnung nach Anspruch 7, dadurch gekennzeichnet, daß die an dem Schaltbrett (30) fest angebrachten, elektrischen Verbindungsteile (46) elektrische Drähte aufweisen, welche zwischen den jeweiligen elektrischen Anschlußöffnungen (60) und den elektronischen Bauelementen angebracht sind.

9. Apparatur zum vereinfachten Entwerfen, Prüfen und Herstellen einer elektronischen Schaltkreisanordnung nach Anspruch 1, dadurch gekennzeichnet, daß der Bogen Pergament (10) mit Verbindungs-Leiteinrichtungen (28) versehen sind, um so ein Aufzeichnen einer speziellen elektrinischen Schaltung (54) auf dem Aufzeichnungsmittel (10) zu vereinfachen, und um ferner ein Herstellen einer integrierten oder gedruckten Schaltung von dem Aufzeichnungsmittel (10) aus zu vereinfachen.

10. Apparatur zum vereinfachten Entwerfen, Prüfen und Herstellen einer elektronischen Schaltkreisanordnung nach Anspruch 9, dadurch gekennzeichnet, daß die Verbindungs-Leiteinrichtung eine Anzahl gestrichelter Linien (28) aufweist, welche auf den Bogen Pergament (10) gedruckt sind, wobei die gestrichelten Linien die gewünschten Verbindungsbahnen zwischen den jeweiligen elektronischen Bauelementen (wie 69) anzeigen und in der richtigen Lage zueinander angebracht sind, so daß keine Kurzschlüsse oder eine elektrische Beeinflussung in einer integrierten oder gedruckten Schaltung vorhanden sind, welche entsprechend einer auf dem Bogen Pergament (10) ausgelegten Schaltung hergestellt worden ist.

11. Apparatur zum vereinfachten Entwerfen, Prüfen und Herstellen einer elektronischen Schaltkreisanordnung nach Anspruch 1, dadurch gekennzeichnet, daß das Schaltbrett ferner mit einer Schaltungsprüfeinrichtung (34) versehen ist, um sicherzustellen, daß die elektronischen Bauelemente innerhalb der vorgeschriebener Parameter betreibbar sind.

12. Apparatur zum vereinfachten Entwerfen, Prüfen und Herstellen einer elektronischen Schaltkreisanordnung nach Anspruch 11, dadurch gekennzeichnet, daß die Schaltungsprüfeinrichtung (34) ferner ein Anzeigefeld (36) mit lichtemittierenden Dioden aufweist, um anzuzeigen, ob die jeweiligen elektronischen Bauelemente (wie 69) innerhalb verlangter Parameter arbeiten.

13. Apparatur zum vereinfachten Entwerfen, Prüfen und Herstellen einer elektronischen Schaltkreisanordnung nach Anspruch 11, dadurch gekennzeichnet, daß die Schaltungsprüfeinrichtung (34) ferner eine Einrichtung (76) zum Prüfen der Funktionsfähigkeit von Transistoren innerhalb gewünschter Parameter aufweist.

14. Apparatur zum vereinfachten Entwerfen, Prüfen und Herstellen einer elektronischen Schaltkreisanordnung nach Anspruch 11, dadurch gekennzeichnet, daß die Schaltungsprüfeinrichtung (34) ferner eine Einrichtung zum Prüfen der elektrischen Energie an den elektronischen Bauelementen aufweist.

15. Apparatur zum vereinfachten Entwerfen, Prüfen und Herstellen einer elektronischen Schaltkreisanordnung nach Anspruch 11, dadurch gekennzeichnet, daß die Schaltungsprüfeinrichtung (34) ferner eine Einrichtung (74) zum Prüfen von Widerstandswerten aufweist, welche Widerständen zugeordnet sind, welche einen Teil der elektronischen Bauelemente bilden.

16. Apparatur zum vereinfachten Entwerfen, Prüfen und Herstellen einer elektronischen Schaltkreisanordnung nach Anspruch 1, dadurch gekennzeichnet, daß das Schaltbrett (30) ferner mit Anschlußflächen (48) versehen ist, welche als Anschlußpunkte zwischen externen Schaltungen und Einrichtungen und dem Schaltbrett (30) dienen.

17. Apparatur zum vereinfachten Entwerfen, Prüfen und Herstellen einer elektronischen Schaltkreisanordnung nach Anspruch 1, dadurch gekennzeichnet, daß das Schaltbrett (3) ferner mit einer außen verlaufenden Anschlußschiene (58) versehen ist, um so eine Verbindung zwischen externen Schaltungen und Einrichtungen und dem Schaltbrett (30) zu vereinfachen.

18. Apparatur zum vereinfachten Entwerfen, Prüfen und Herstellen einer elektronischen Schaltkreisanordnung nach Anspruch 1, dadurch gekennzeichnet, daß das Schaltbrett (30) ferner eine Stromversorgungseinrichtung (70) zum Ansteuern der jeweiligen elektronischen Bauelemente aufweist, welche dem Schaltbrett (30) zugeordnet sind.

19. Apparatur zum vereinfachten Entwerfen, Prüfen und Herstellen einer elektronischen Schaltkreisanordnung nach Anspruch 18, dadurch gekennzeichnet, daß die Stromversorgungseinrichtung intern untergebrachte Batterien (70) aufweist.

20. Apparatur zum vereinfachten Entwerfen, Prüfen und Herstellen einer elektronischen Schaltkreisanordnung nach Anspruch 1, dadurch gekennzeichnet, daß Ersatzteile in einem inneren Bereich der Apparatur vorgesehen sind.

21. Apparatur zum vereinfachten Entwerfen, Prüfen und Herstellen einer elektronischen Schaltkreisanordnung nach Anspruch 1, dadurch gekennzeichnet, daß die elektronischen Bauelemente auswechselbar fest angebracht sind, um so wahlweise einzelne der elektronischen Bauelemente entnehmen zu können, und um sie durch andere elektronische Bauelemente ähnlicher Ausführung ersetzen zu können.

22. Apparatur zum vereinfachten Entwerfen, Prüfen und Herstellen einer elektronischen Schaltkreisanordnung nach Anspruch 1, dadurch gekennzeichnet, daß die Identifizierungsmittel (28) zum bequemen Identifizieren der jeweiligen elektronischen Bauelemente farbkodiert sind.

23. Apparatur zum vereinfachten Entwerfen, Prüfen und Herstellen einer elektronischen Schaltkreisanordnung nach Anspruch 22, dadurch gekennzeichnet, daß der Bogen Pergament (10) in gleicher Weise wie eine Farbkodierung der Identifizierungsmittel (28) farbkodiert ist, um so eine Identifizierung der jeweiligen elektronischen Elemente zwischen dem Schaltbrett (30) und dem Bogen Pergament (10) zu vereinfachen.

24. Methode zum Ausführen einer Apparatur zum vereinfachten Entwerfen, Prüfen und Herstellen einer elektronischen Schaltkreisanordnung, bei welcher eine Anzahl elektronischer Bauelemente (wie 69) auf einer Seite (62) eines Schaltbretts (30) fest angebracht werden, die Anzahl elektronischer Bauelemente über einen Anordnungsplan für elektronische Bauelemente auf der anderen Seite (32) des Schaltbretts (30) identifiziert werden, und eine Einrichtung (46) zum Zusammenschalten der jeweiligen elektronischen Bauelemente des Schaltbretts vorgesehen ist, um so ein vollständiges Auslegen einer elektronischen Schaltung zu vereinfachen, dadurch gekennzeichnet, daß ein Bogen Pergament (10) mit einem zweiten aufgedruckten Anordnungsplan für elektronische Bauelemente vorgesehen wird, wobei der zweite Anordnungsplan eine identische Darstellung des auf dem Schaltbrett (10) vorgesehenen Anordnungsplan für elektronische Bauelemente ist, so daß der zweite Anordnungsplan für elektronische Bauelemente dazu verwendet werden kann, eine ganz bestimmte, elektronische Schaltung (wie 54), welche an dem Schaltbrett (30) ausgeführt werden kann, gesondert darzustellen und dauerhaft aufzuzeichnen.

25. Methode zum Ausführen einer Apparatur zum vereinfachten Entwerfen, Prüfen und Herstellen einer elektronischen Schaltkreisanordnung nach Anspruch 24 dadurch gekennzeichnet, daß eine Schaltungsprüfeinrichtung (34) in Verbindung mit dem Schaltbrett vorgesehen wird, um so ein selektives Prüfen der elektronischen Bauelemente (69) zu vereinfachen.

26. Methode zum vereinfachten Entwerfen, Prüfen und Herstellen einer elektronischen Schaltkreisanordnung nach Anspruch 24, dadurch gekennzeichnet, daß gestrichelte Leitlinien (28) zwischen den jeweiligen elektronischen Bauelementen auf dem Bogen Pergament (10) vorgesehen werden, um eine Kennzeichnung gewünschter Verbindungen zwischen den elektronischen Bauelementen zu vereinfachen.

27. Methode zum vereinfachten Entwerfen, Prüfen und Herstellen einer elektronischen Schaltkreisanordnung nach Anspruch 26, dadurch gekennzeichnet, daß die Leitlinien (28) in einer Weise angeordnet werden, daß eine integrierte oder gedruckte Schaltung von dem Bogen Pergament (10) aus hergestellt werden kann, indem elektronische Verbindungsleitungen über den gestrichelten Linien (28) so positioniert werden, daß irgendwelche Kurzschlüsse und eine elektrische Beeinflussung ohne Belang sind.

28. Methode zum vereinfachten Entwerfen, Prüfen und Herstellen einer elektronischen Schaltkreisanordnung nach Anspruch 26, dadurch gekennzeichnet, daß der Bogen Pergament (10) mit der dauerhaft aufgezeichneten, elektronischen Schaltung verwendet wird, um eine integrierte oder gedruckte Schaltung herzustellen.

*Fig. 1*

0 051 304

Fig. 2

**Fig. 3**

**Fig. 4**